# EUROPEAN PATENT APPLICATION

(11) **EP 0 845 847 A1**
(43) Date of publication of application: **03.06.1998**
(21) Application number: 96830602.7
(22) Date of filing: 29.11.1996
(51) Int. Cl.: H02H 9/04

(54) **Device for the protection of MOS integrated circuit terminals against electrostatic discharges**

(71) Applicant: SGS-THOMSON MICROELECTRONICS s.r.l., 20041 Agrate Brianza (Milano) (IT)
(72) Inventor: Colombo, Paolo, 21049 Tradate (Varese) (IT)

(57) **Abstract**

Device for protection against electrostatic discharges on the terminals of a MOS integrated circuit and characterized in that it comprises a first (N1,N2) and a second circuit branches (R1,N3,R2;T,R) between the terminal to be protected (VPP PAD) and ground with the first circuit branch comprising a first (N1) and a second field-effect transistors and having respective gate terminals connected respectively to the terminal and to a first end of a first resistance (R2;R) included in the second circuit branch and having a second end connected to ground.

The second circuit branch comprises a third field-effect transistor (N3) having its gate terminal connected to ground and a second resistance (R1) inserted between the third transistor (N3) and the terminal to be protected.

## Description

### Field of application

The present invention relates to a MOS integrated circuit and specifically to a device for protection against electrostatic discharges on the I/O (input and output) terminals of the integrated circuits of this type or on terminals for powering them and which could be the one for programming in the case of non-volatile memory cells.

It is known that the terminals of an integrated circuit are subject to accidental contact with electrically charged bodies during manufacture and assembly in a circuit complex or during operation so that there can be created differences of potential of a magnitude even very significant, for example between the gate electrodes of the input transistors or between the drain regions of the output transistors and the substrate of semiconductor material on which the integrated circuit is formed. In the first case, as soon as the potential differential exceeds the dielectric rigidity threshold of the gate insulation the transistor is put out of service by the electrostatic discharge which develops through the insulation and in the second case there occurs a similar destructive effect as soon as the potential difference exceeds the inverse breakdown threshold of the drain junction. Again by way of example, in a CMOS integrated circuit manufactured with 1.2 µm technology (i.e. with minimum gate dimensions of 1.2 µm) the breakdown voltage for the input transistors is 12 V to 14 V and that of the output transistors is approximately 12 V.

Various remedies are known for protecting the different input, output and power supply terminals from electrostatic discharges. Some of them use resistors in series and diodes in series and/or in parallel and integrated in the substrate on which is formed the integrated circuit to limit or shunt the currents resulting from the electrostatic discharges and lend themselves essentially to protection of input terminals while others use structures of the thyristor discharge or SCR (Silicon Controlled Rectifier) type in parallel and can be used for the protection of both input and output terminals.

In many cases protection devices using lateral bipolar transistors are also used effectively.

A known protection devices particularly suited to being integrated monolithically in a MOS integrated circuit to be protected is described for example in Italian patent application no. 26063 A/80 filed by this applicant.

This device consists essentially of an NPN lateral transistor with emitter and collector doped with type N impurities simultaneously with and identically to the source and drain regions of the IGFT of the MOS circuit to be protected and with inaccessible base heavily and deeply doped with acceptor ions (type P impurities) by ion implantation.

In Italian patent application no. 23077A/85 of this applicant there is described a perfected use of the same structure. The protection comprises a first and second lateral bipolar transistors having collector terminals connected respectively to the input terminal of the circuit and to the gate electrodes of the IGFT and having emitter terminals both connected to a ground terminal and a diffuse resistor (R') connecting the collectors of the two lateral transistors.

The width of the base of the first transistor and the concentration of impurities in the bases of both the two lateral transistors are such as to keep the ignition voltage of the negative resistance phenomena of the first lateral transistor and the breakdown voltage of the second lateral transistor at a value lower than the breakdown voltage of the gate insulating oxides and the breakdown voltage of the bipolar junctions included in the integrated circuit and such as to keep the sustaining voltage of the first lateral transistor at a value higher than the supply voltage of the integrated circuit.

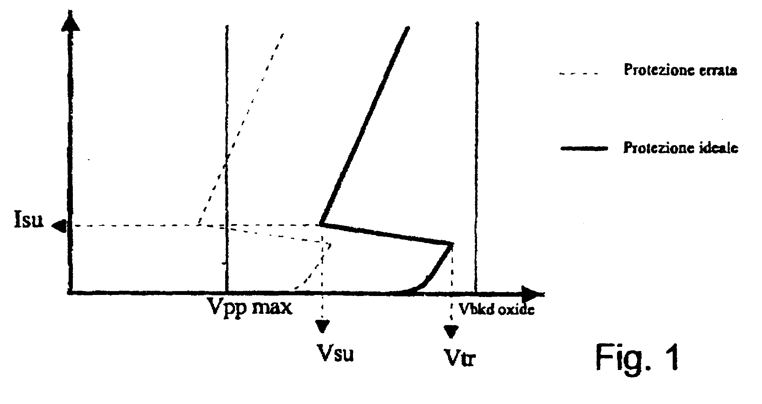

We shall now discuss specifically the protection requirement for the Vpp voltage supply terminals for non-volatile memory cell programming. The ideal protection indicated in FIG 1 for this type of supply should ignite by snap-back before the breakdown voltage of the cell gate oxides and be able to sustain on voltages higher than the value of max-rating (13.2V typical for Vpp) also having to ensure static functionality following voltage spikes.

Lateral bipolar transistor protections usually implemented for the input/output terminals do not entirely satisfy the Vpp dedicated functionality requirements. An 18V trigger voltage is for example acceptable while a 9V sustaining voltage implies that in case of ignition for a spike on Vpp the bipolar protection transistor would remain on because fed by this power supply.

By applying special contrivances to the collector junction and using special process systems it is possible to obtain lateral bipolar transistors having acceptable clamp values and lateral bipolars with less doped collector scattering (n-) typically display Vtrig=21-23V, Vsu=14V.

These solutions have three shortcomings, as follows.
- The protection structures are dependent on the particular device manufacturing process,
- the lateral bipolar transistors readily display deterioration after ESD caused by trapping of charge in the 'beak' of the oxide overlying the base region (soft leakage), and
- the trigger voltage is higher than the breakdown voltage of an n+ junction towards the insulation system with less difference with respect to the Vbkdox voltage.

Another bipolar solution with resistive divider displays the shortcoming of introducing a resistance in the path between terminal pad and internal circuitry and therefore during memory cell programming it is possible to not have available the necessary Vpp fraction on the cell gate.

The technical problem underlying the present invention is to provide a protection device against electrostatic discharges (ESD) on the terminals of a MOS integrated circuit which would be particularly effective for protection of cell programming power supply terminals in the case of integrated circuits having non-volatile memory cells.

The technical problem is solved by a protection device against electrostatic discharges of the type indicated above and define in the characterizing part of the claims which follow this description.

The characteristics and advantages of the protection device against electrostatic devices in accordance with the present invention are set forth in the description of an embodiment thereof given below by way of non-limiting example with reference to the annexed drawings.

In the drawings:
FIG 1 shows graphically the manner of operation of a protection device which is effective against electrostatic discharges,
FIGS 2 and 3 show two circuit diagrams in accordance with which can be implemented a protection device in accordance with the present invention, and
FIG 4 shows a cross section of a monolithically integrated structure which is a possible implementation of the basic part of a protection device in accordance with the present invention.

### Detailed description

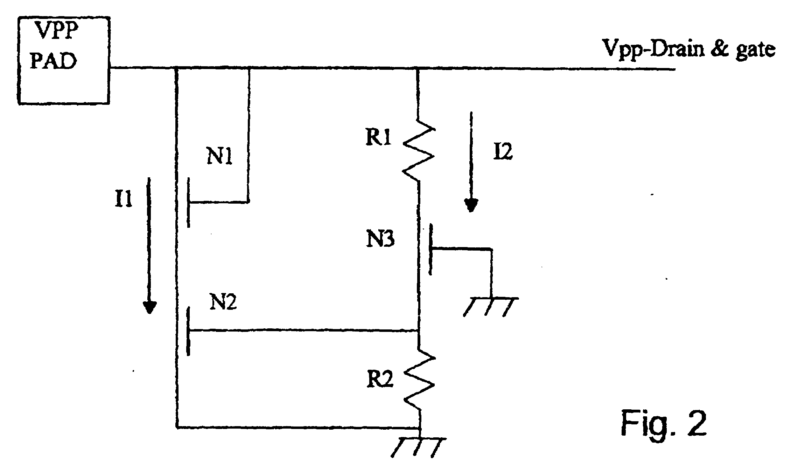

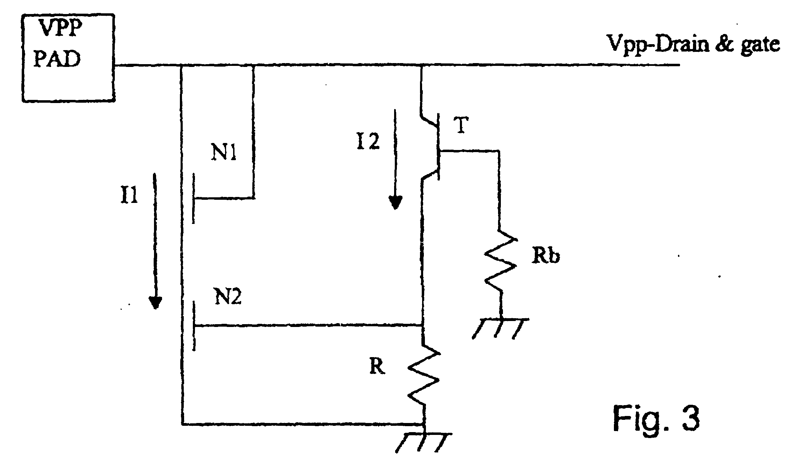

As shown in FIGS 2 and 3 the circuit structure of a protection device against electrostatic discharges in accordance with the present invention comprises a main branch through which must be dissipated the electrostatic energy consisting in both cases of two field-effect transistors in cascode configuration and an ignition circuit branch which can be implemented in different ways to optimize the operating mode.

The following observations are made essentially for the purpose of optimizing a specific protection mechanism for electrostatic discharges on a voltage supply terminal Vpp (pad) for non-volatile memory cell programming in a MOS integrated circuit.

A protection device in accordance with the present invention can be used effectively even in the other usual applications for integrated circuit input and output terminals.

In the basic structure the field-effect transistors N1 and N2 are the NMOS type.

In FIGS 2 and 3 the transistor N1 is diode-connected while the gate terminal of the transistor N2 is connected to ground through a resistor of the ignition branch with R2 in FIG 2 and R in FIG 3.

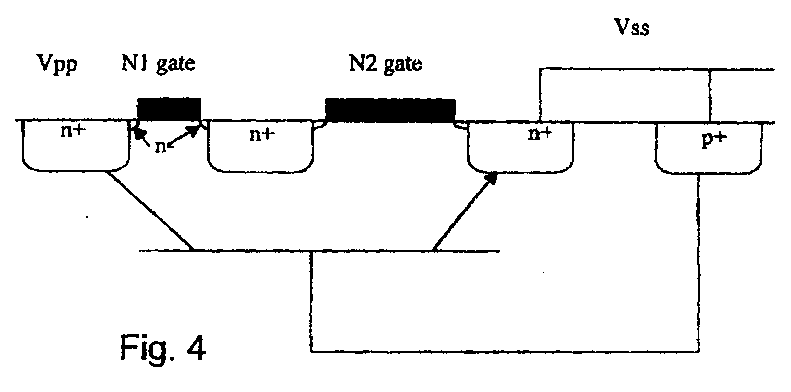

The first transistor N1 is diode connected and must be topologically short to reduce the series resistance in the branch and the diode connection makes it immune to stress on the gate oxide. The second transistor N2 is driven by the second branch. Functionality is ensured by the fact that the integrated structure parasite bipolar (cross section in FIG 4), being topologically very long, carrying voltages for ideal Vpp protection as shown in FIG 1.

The ignition branch of the base structure consists of a resistor R1 diffused in n+ of approximately 100 Ohm for protection of the gate oxide of a NMOS (N3) gated to ground and a resistor R2 in n-well of approximately 1000 Ohm. Ignition takes place through the voltage drop on the resistance R2 following starting of the parasite bipolar transistor of N3. As it is important to reduce the ignition time of this bipolar transistor, N3 can be provided as a MOS with short channel.

Functionality is ensured by the highly resistive path of the branch. Assuming a spike causing snap-back of the transistor N3, at the end of the spike the voltage at the ends of N3 is at the worst 8V. The total resistance of the branch is evaluated in such a manner that the current 12 is less than the Isu, as follows.$\frac{\text{Vpp} \text{- 8[} \text{V} \text{]}}{\text{R} \text{1 +} \text{R} \text{2 +} \text{R} \text{(} \text{N} \text{3)}} \text{≤} \text{Isu}$ where R(N3) represents the dynamic resistance of the parasite bipolar of N3; and
Vpp is the programming voltage.

The main advantages of this circuit structure shown in FIG 2 are the following.

The trigger voltage of the structure is limited to the breakdown voltages of the conventional gated junctions and is thus less than that of a standard bipolar transistor.

No resistive path is necessary between the pad and the memory cell programming circuitry.

In the pilot branch the unprotected gated MOS structure which is notoriously critical for ESD has been avoided.

There are no problems linked to charge trapping in the field oxide.

The protection structure is independent of the process so that no additional costs are required. Concerning implementation and layout the integration surface area occupied can be minimized by arranging the basic structure on two branches and occupies a surface area smaller than the usual one for ESD protection with divider.

FIG 3 shows a different architecture of the pilot branch. The basic structure ignition branch consists of a topologically short bipolar transistor followed by an n-well resistance R of approximately 1000 Ohm. Ignition takes place through the voltage drop on the resistance R. As it is important to reduce the ignition time of the bipolar transistor it is appropriate to make it with a narrow base.

Functionality is ensured by the highly resistive path of the branch. The total resistance of the branch is evaluated in such a manner that the current I2 is less than the Isu, as follows.$\frac{\text{Vpp} \text{- 8[} \text{V} \text{]}}{\text{R} \text{+} \text{R} \text{(} \text{bip} \text{)}} \text{≤} \text{Isu}$ where R(bip) represents the dynamic resistance of the lateral bipolar transistor T; and
Vpp is the programming voltage.

With respect to the circuit structure of FIG 2 there is no problem of protection of the gate oxide of a MOS transistor and therefore there is better intrinsic strength in addition to a reduction of the integration surface area occupied. However the use of a bipolar transistor can give rise to soft-leakage problems and ignition delay because of the higher trigger voltage with respect to a gated junction.

Modifications or substitutions to the embodiments described above can be made in a manner known to one of ordinary skill in the art.

## Claims

1. Device for protection against electrostatic discharges on the terminals of a MOS integrated circuit and characterized in that it comprises a first (N1,N2) and a second circuit branches (R1,N3,R2;T,R) between the terminal to be protected (VPP PAD) and ground with the first circuit branch comprising a first (N1) and a second field-effect transistors and having respective gate terminals connected respectively to the terminal and to a first end of a first resistance (R2;R) included in the second circuit branch and having a second end connected to ground.

2. Device for protection against electrostatic discharges in accordance with claim 1 and characterized in that the second circuit branch comprises a third field-effect transistor (N3) having its gate terminal connected to ground and a second resistance (R1) inserted between the third transistor (N3) and the terminal to be protected.

3. Device for protection against electrostatic discharges in accordance with claim 1 and characterized in that the second circuit branch comprises a bipolar transistor inserted between the first resistance (R) and the terminal to be protected and having a base terminal connected to ground through a base resistance (Rb).

4. Device for protection against electrostatic discharges in accordance with claim 3 and characterized in that topologically the bipolar transistor (T) integrated in the device is short and has a narrow base region.

5. Protection device in accordance with any of the above claims and characterized in that the first (N1) and the second (N2) field-effect transistors are connected together in accordance with a cascode configuration.

6. Protection device in accordance with claim 5 and characterized in that the first (N1) and the second (N2) field-effect transistors are the NMOS type.
